# EUROPÄISCHE PATENTANMELDUNG

(11) **EP 2 199 808 A1**
(43) Veröffentlichungstag der Anmeldung: **23.06.2010**
(21) Anmeldenummer: 09012480.1
(22) Anmeldetag: 01.10.2009
(51) Int. Cl.: G01R 13/02, G01R 23/18

(54) **Verfahren und Vorrichtung für eine digitale Anzeige eines Messgeräts**

(30) Priorität: 17.12.2008 DE 102008062695
(71) Anmelder: Rohde & Schwarz GmbH & Co. KG, 81671 München (DE)
(72) Erfinder: Hisch, Martin, 85661 Forstinning (DE)
(74) Vertreter: Beder, Jens

(57) **Zusammenfassung**

Das erfindungsgemäße Verfahren zur Messdatenverarbeitung mittels eines erfindungsgemäßen Messgeräts 10 weist die folgenden Schritte auf. Eine Mehrzahl von zeitlich aufeinanderfolgenden Einzelspektren eines Signals wird in einem bestimmten Zeitintervall und in einem gleichbleibenden Frequenzband mittels einer Messvorrichtung 12 gemessen. Die Häufigkeit des Auftretens eines jeden Spektralwertes wird aus der Gesamtheit der in dem bestimmten Zeitintervall gemessenen Einzelspektren mittels einer Akkumulationsvorrichtung 21 berechnet. Nur die Spektralwerte, die in einer ausgewählten Teilmenge der möglichen Auftrittshäufigkeiten der Spektralwerte liegen, werden mittels einer Filtervorrichtung 22 isoliert und auf einer Anzeigevorrichtung 15 dargestellt.

## Beschreibung

Die Erfindung betrifft ein Verfahren und eine Vorrichtung für eine digitale Anzeige eines Messgeräts.

Messgeräte zur Spektralanalyse messen und berechnen eine Größe, wie z.B. eine Leistung oder Phase eines Messsignals in Abhängigkeit der Frequenz. Ein typischer Vertreter solcher Messgeräte ist der Spektralanalysator, der ein Leistungsspektrum eines Eingangssignals misst. Das Leistungsspektrum wird jeweils für nacheinander liegende Zeitfenster des Eingangssignals berechnet oder direkt gemessen, so dass eine zeitliche Entwicklung des Leistungsspektrums des Eingangssignals ermittelbar ist. Die zeitlich nacheinander gemessenen Einzelspektren werden normalerweise nacheinander auf einen Bildschirm gegeben, um eine zeitliche Entwicklung des Spektrums darzustellen.

Durch das Nachleuchten und durch die Proportionalität zwischen Farbintensität und der Anzahl an überlagerten Funktionen an einem Punkt bei analogen Bildschirmen wurde für den Benutzer eines Spektralanalysators eine Überlagerung von identischen Spektralwerten der letzten Einzelspektren sichtbar. Durch die positive Überlagerung der Einzelspektren wurden stationäre Signale von Kurzzeitsignalen und Rauschen unterscheidbar und der Benutzer hatte aus einer einfachen Darstellung einen relativ hohen Informationsgewinn.

Digitale Bildschirme (z.B. TFT-Displays) zeigen diese positiven Eigenschaften nicht. Werden die Spektren nacheinander auf einen digitalen Display gegeben, wechseln die Spektren schneller als das Auge dies auflösen kann, da der Zeitabstand zwischen zwei aufeinanderfolgend gemessenen Spektren i.d.R. wesentlich geringer als das Auflösungsvermögen des Auges ist. Lässt man die Spektren länger auf dem Bildschirm angezeigt, als bis zum darauffolgend darzustellenden Einzelspektrum, um einen analogen Effekt zu erhalten, sammeln sich eine bestimmte Anzahl an Spektren auf dem Bildschirm an, die nicht mehr unterscheidbar und zuzuordnen sind, da alle angezeigten Spektralwerte die gleiche Intensität oder Farbe haben.

Die deutsche Offenlegungsschrift DE 10 2004 040 473 A1 offenbart einen digitalen Leuchtstoff-Spektralanalysator, der auf einem digitalen Bildschirm eines Spektralanalysators das Verhalten und Aussehen eines analogen Bildschirms emuliert. Dabei wird eine gewisse Menge an zuletzt gemessenen Einzelspektren gesammelt und diese Mehrzahl von Einzelspektren gleichzeitig auf dem Bildschirm dargestellt. Die Farbintensität eines jeden dargestellten Spektralwerts auf dem Bildschirm ist dabei proportional zu der Anzahl des Auftretens dieses Spektralwertes in der Gesamtheit der verschiedenen gemessenen Einzelspektren. Die Farbintensität der Darstellungspunkte kann entsprechend eines komplexen Algorithmus zwischen den Darstellungspunkten des jeweiligen Spektrums verteilt werden. Die Farbintensität der Gesamtheit der dargestellten Spektren wird zusätzlich noch mit einer Abklingfunktion reduziert, um ein möglichst analog-ähnliches Bildschirmbild zu erzeugen.

Ein Nachteil dieser Darstellung ist, dass die Darstellung aller Spektralwerte oft unübersichtlich ist. Vor allem viele, nahe beieinander liegende Farbnuancen sind oft für das menschliche Auge schwer zu unterscheiden. Der angestrebte Informationszuwachs wird damit nicht erreicht.

Die Aufgabe der Erfindung ist es, Darstellungsdaten zur Ansteuerung eines digitalen Displays so zu bearbeiten, dass sie von dem Benutzer einfach, übersichtlich und ohne starke Beanspruchung des menschlichen Auges aufgenommen werden können. Dies soll möglichst einfach und ohne großen Rechenaufwand geschehen, was insbesondere für Echtzeitanwendungen wichtig ist.

Die Aufgabe wird durch ein erfindungsgemäßes Verfahren nach Anspruch 1 und durch ein erfindungsgemäßes Messgerät nach Anspruch 8 gelöst.

Das erfindungsgemäße Verfahren zur Messdatenverarbeitung gemäß Anspruch 1 weist die folgenden Schritte auf. Eine Mehrzahl von zeitlich aufeinanderfolgenden Einzelspektren eines Signals wird in einem bestimmten Zeitintervall und in einem gleichbleibenden Frequenzband gemessen. Die Häufigkeit des Auftretens eines jeden Spektralwertes wird aus der Gesamtheit der in dem bestimmten Zeitintervall gemessenen Einzelspektren berechnet. Die Spektralwerte, die in einer ausgewählten Teilmenge der möglichen Auftrittshäufigkeiten der Spektralwerte liegen, werden auf einer Anzeigevorrichtung dargestellt.

Ein erfindungsgemäßes Messgerät gemäß Anspruch 8 weist die folgenden Vorrichtungen auf. Eine Messvorrichtung zum Ermitteln einer Mehrzahl von zeitlich aufeinanderfolgenden Einzelspektren eines Signals im jeweils gleichen Frequenzbereich. Eine Anzeigevorrichtung zur Darstellung von Spektralwerten dieser Einzelspektren über die Frequenz und eine Akkumulationsvorrichtung verbunden mit der Anzeigevorrichtung und der Messvorrichtung. Die Akkumulationsvorrichtung ist zur Berechnung der Darstellungsdaten aus den Spektraldaten der gemessenen Einzelspektren der Messvorrichtung ausgelegt, so dass alle Einzelspektren aus einem bestimmten Zeitbereich gesammelt werden und die Häufigkeit des Auftretens eines jeden Spektralwertes aus der Gesamtheit der in dem bestimmten Zeitintervall gemessenen Einzelspektren berechenbar ist. Eine Filtervorrichtung ist verbunden mit der Akkumulationsvorrichtung und der Anzeigevorrichtung zur Reduzierung der Darstellungsdaten auf die Spektralwerte, die in einer ausgewählten Teilmenge der möglichen Auftrittshäufigkeiten der Spektralwerte liegen. Unter Reduzierung der Darstellungsdaten wird dabei verstanden, dass das den Bildschirm ansteuernde Signal nur die Informationen (= Darstellungsdaten) enthält, die zur Anzeige der bezüglich der Häufigkeit in dem gewählten Intervall erforderlich sind. Im übrigen wird die Hintergrunddarstellung beibehalten.

Dadurch werden nur die Spektralwerte eines bestimmten Häufigkeitsbereichs dargestellt. Dies hat den Vorteil, dass der Benutzer auswählen kann, welche Häufigkeiten ihn interessieren, z.B. geringe Häufigkeiten bei der Untersuchung von Kurzzeitsignalen, und konzentriert nur diese auf dem Bildschirm darstellen. Das menschliche Auge ist somit neben der Erfassung der Dynamik der Spektren nicht noch zusätzlich mit der Erfassung der Häufigkeit belastet. Dies erleichtert dem Benutzer vor allem das Analysieren bestimmter, nur zeitweise auftretender Signale.

Die Unteransprüche betreffen vorteilhafte Weiterführungen der Erfindung.

Vorteilhaft ist es, dass die Teilmenge der möglichen Häufigkeiten des Auftretens der dargestellten Spektralwerte einstellbar ist. So kann der Benutzer die ihn interessierende Teilmenge der möglichen Häufigkeiten selbst auswählen. Dies kann zum Beispiel besonders vorteilhaft durch die Auswahl eines minimalen und eines maximalen Häufigkeitswerts auf einer der Häufigkeit entsprechenden Farbskala eingestellt werden. Dies erlaubt eine einfache und intuitive Bedienung des Messgeräts.

Weiterhin vorteilhaft ist es, dass sich die Teilmenge aus mehreren einzelnen Teilbereichen der möglichen Häufigkeiten der Spektralwerte zusammensetzt. Dadurch kann der Benutzer auch mehrere zu untersuchende Bereiche auswählen und die dazwischen liegenden Häufigkeitsbereiche ausblenden. Auch überlappende Bereiche sind denkbar.

Vorteilhaft ist es auch, dass Darstellungsdaten zunächst für alle Spektralwerte entsprechend ihrer Häufigkeit des Auftretens optisch unterscheidbar ermittelt werden und vor deren Zuführung zu dem digitalen Bildschirm diejenigen Spektralwerte, die nicht in einer Häufigkeit der Teilmenge auftreten, mittels der optischen Eigenschaften der nicht dargestellten Spektralwerte herausgefiltert werden. Dadurch lässt sich die Filtervorrichtung besonders einfach realisieren, da ein Standard-Filter der Bildverarbeitung verwendet werden kann, der die entsprechenden optischen Eigenschaften, z.B. Farben oder Helligkeitswert herausfiltert.

Ein Ausführungsbeispiel der Erfindung wird nachstehend anhand der Zeichnung beschrieben. Die Zeichnung zeigt:
- Fig. 1: eine schematische Darstellung eines Ausführungsbeispiels des erfindungsgemäßen Messgeräts;
- Fig. 2: ein Blockdiagramm der Schritte eines Ausführungsbeispiels des erfindungsgemäßen Verfahrens;
- Fig. 3: ein Ausführungsbeispiel für die Aufbereitung der Spektraldaten für den Bildschirm des erfindungsgemäßen Messgeräts;
- Fig. 4: ein Ausführungsbeispiel für die Aufbereitung der Spektraldaten für den Bildschirm eines Messgeräts des Stands der Technik;

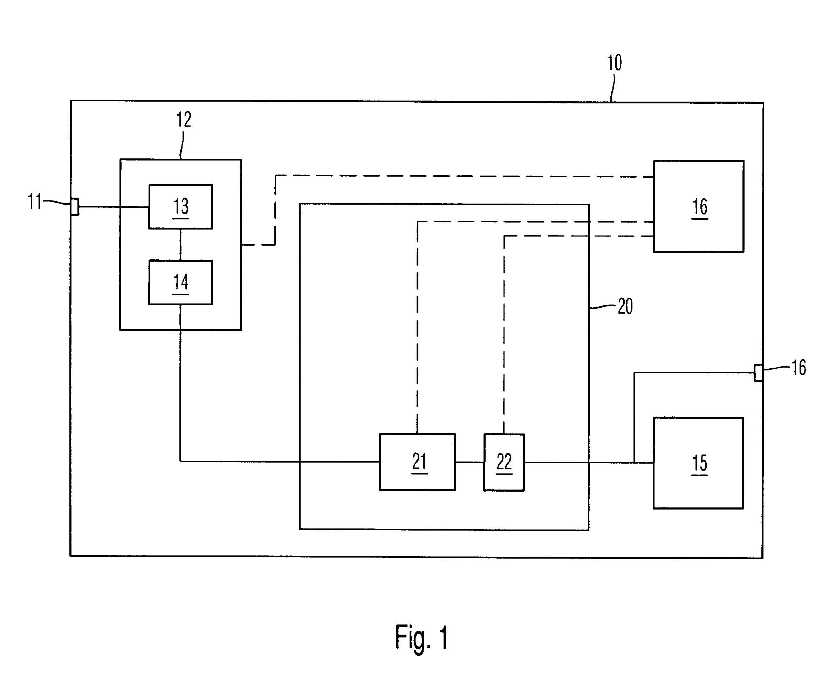

Fig. 1 zeigt ein Spektrumsanalysator 10 als Messgerät. Die Erfindung ist besonders vorteilhaft für einen Spektrumsanalysator 10, insbesondere auch für einen Überwachungsempfänger zur Beobachtung von Empfangsspektren an Antennen. Dabei treten vor allem stationäre Signale in Kombination mit Kurzzeitsignalen auf, welche mit der Erfindung besonders gut beobachtbar sind. Die Erfindung ist allerdings nicht auf Spektrumsanalysatoren 10 beschränkt, sondern ist auf jedes Messgerät übertragbar, welches ein Größe in Abhängigkeit der Frequenz misst oder berechnet.

Am Eingang 11 wird ein Messsignal angelegt und an eine Messvorrichtung 12 gegeben. Die Messvorrichtung 12 misst dabei die Leistung in Abhängigkeit der Frequenz und gibt die gemessenen Einzelspektren in festen Zeitabständen an ein Steuergerät 20. So kann zum Beispiel das Messsignal über einen Analog-/Digital-Wandler 13 digitalisiert werden und in digitaler Form an einen Spektrumsrechner 14 gegeben werden. Der Spektrumsrechner 14 berechnet auf der Basis eines Zeitfensters, welches z.B. die letzten 2048 Samplingpunkte des Messsignals enthält und deren Länge durch einen Benutzer einstellbar ist, ein Einzelspektrum auf der Basis eines gängigen Schätzers für das Leistungsspektrum, z.B. das Periodogramm. Der zu verwendende Schätzer kann dabei vom Benutzer über eine Eingabevorrichtung 16 ausgewählt werden, da je nach Art des Messsignals manche Schätzer besser geeignet sind. Die Daten des Leistungsspektrums werden als Einzelspektrum an die Steuervorrichtung 20 geschickt, während bereits die neu von dem Analog-/Digital-Wandler 13 angelieferten Datenpunkte in dem Spektrumsrechner 14 zwischengespeichert werden. Ist eine festgelegte Anzahl an neuen Samplingpunkten an den Spektrumsrechner 14 geschickt worden, kann aus den neuen oder bei gleitendem Zeitfenster teilweise neuen letzten 2048 Samplingpunkten des Messsignals ein neues Einzelspektrum berechnet werden, welches wiederum an die Steuervorrichtung 20 gegeben wird. So werden im Betrieb näherungsweise ohne Zeitverzögerung, die Spektren des aktuell am Eingang 11 gemessenen Signals an die Steuervorrichtung 20 gegeben werden.

Über die Anzahl der Samplingpunkte für das Zeitfenster zur Spektrumsberechnung, über den Überlapp der Zeitfenster bzw. der Anzahl der Samplingpunkte, die das Zeitfenster vor Ermittlung des nächsten Einzelspektrums weitergeschoben wird, und über die Samplingrate kann Qualität, Zeitauflösung und Frequenzauflösung der Einzelspektren entsprechend der Erfordernisse und des zu messenden Signals über die Eingabevorrichtung 16 eingestellt werden. Für die Erfindung ist vor allem die Anzahl der Samplingpunkte, die das Zeitfenster vor Ermittlung des nächsten Einzelspektrums weitergeschoben wird, relevant, da die Anzahl multipliziert mit der Samplingrate des Messsignals die Zeit zwischen zwei Einzelspektren festlegt. Diese Zeit liegt in der Regel einige Größenordnungen unter dem zeitlichen Auflösungsvermögen des Auges.

Die Messvorrichtung 12 ist hier nur exemplarisch beschrieben und ist nicht beschränkend für die Erfindung. Es können auch mittels Heterodynempfängern Leistungen spezieller Frequenzen direkt gemessen werden und danach digitalisiert werden. Die Messvorrichtung 12 berechnet oder misst in regelmäßigen Zeitabständen ein Einzelspektrum, welches das Eingangsmesssignal zu diesem Zeitpunkt bzw. in diesem Zeitfenster repräsentiert, und gibt dieses in den gleichen regelmäßigen Abständen an die Steuervorrichtung 20. Wird eine andere spektrale Größe gemessen, wird in der Messvorrichtung 12 ein entsprechendes Spektrum dieser Größe gemessen oder berechnet und an die Steuervorrichtung 20 gegeben.

Für die gleichen Grundeinstellungen bezüglich der Messung der Einzelspektren, überdeckt jedes gemessene Einzelspektrum den gleichen Frequenzbereich. Der Frequenzbereich liegt zwischen einer Start- und einer Stoppfrequenz, die jeweils umgestellt werden können.

Die Einzelspektren werden in der Steuervorrichtung 20 in einer Akkumulationsvorrichtung 21 zur Ermittlung von Darstellungsdaten zur Ausgabe von Informationen über das Messergebnis gespeichert. Dabei wird eine festgelegte Anzahl N an Spektren gespeichert. Nach dem Beginn einer Messung wird zuerst ein Speicher mit den N Einzelspektren vollgeschrieben und darauffolgend wird immer das älteste Einzelspektrum durch das zuletzt gemessene Einzelspektrum von der Messvorrichtung 12 in dem Speicher der Akkumulationsvorrichtung 21 ersetzt. Somit stehen zu jedem Zeitpunkt die letzten N Spektren zur Verfügung.

In der Akkumulationsvorrichtung 21 werden nun die Darstellungsform und die Darstellungsdaten der gesammelten N Spektren für eine Anzeigevorrichtung, die hier als digitaler Bildschirm 15 realisiert ist, berechnet. Der digitale Bildschirm 15 weist eine gewisse Anzahl nx an Pixeln in der Richtung der x-Achse und eine gewisse Anzahl ny an Pixeln in der Richtung der γ-Achse auf. Die Daten der Spektren, die als Leistungs-Frequenz-Tupel gespeichert sind, müssen in Bildschirmpunkte (x, y) umgerechnet werden, um auf dem digitalen Bildschirm 15 dargestellt werden zu können. Dazu werden den nx Pixeln oder einer Teilmenge davon Frequenzen von der eingestellten Startbis zur Stoppfrequenz zugeordnet bzw. einem vergrößerten Frequenzbereich dazwischen zugeordnet. Damit entspricht jeder Pixel der nx Pixel oder der Teilmenge davon einem Frequenzwert. Die Messvorrichtung liefert pro Einzelspektrum eine Anzahl unabhängiger Leistungswert-Frequenz-Tupel. Da normalerweise mehr unabhängige Spektralwerte gemessen werden als Pixel nx auf dem Bildschirm zur Verfügung stehen, müssen den Pixelwerten x normalerweise mehrere Frequenzwerte bzw. ein Frequenzbereich zugeordnet werden und die zu den Frequenzwerten gehörenden Spektralwerte gemittelt oder auf andere Weise zusammengefasst werden. Für den seltenen Fall, dass weniger unabhängige Spektralwerte gemessen werden als Pixelwerte nx zur Verfügung stehen, können die Spektralwerte der Pixel ohne einen zugehörigen Spektralwert durch Interpolation oder durch eine Linearkombination der unabhängigen Fourierkoeffizienten, falls diese noch vorliegen, berechnet werden. Den ny Pixeln in der y-Richtung werden entsprechend Leistungswerte oder vorzugsweise logarithmierte Leistungswerte zwischen deren Minimum und Maximum oder in einem benutzerdefinierten Leistungsbereich zugeordnet. Die Umrechnung von Leistungs-Frequenz-Tupeln (A, f) in PixelTupel (x, y) kann dabei alternativ auch vor der Speicherung der Spektren, nach der Weiterverarbeitung der gesammelten Spektren oder auch erst kurz vor einem Bildschirm 15 geschehen.

Soll ein Einzelspektrum auf dem Bildschirm 15 dargestellt werden, kann nun jedes Pixeltupel (x, y), welches aus den Leistungs-Frequenz-Tupeln (A, f) eines jeden Einzelspektrums berechnet wurde, eine Farbe zugeordnet werden, um das Einzelspektrum optisch auf dem digitalen Bildschirm 15 sichtbar zu machen. Um nun alle gesammelten N Spektren darzustellen, werden pro xi Pixel, d.h. pro Pixelspalte i des digitalen Bildschirms, alle N Pixeltupel { (xi, yj) | j =1, ..., N } für jedes Einzelspektrum berechnet. D.h. es existieren pro x-Pixel N y-Pixelwerte als Spektralwerte A. Tritt nun ein Pixeltupel (x, y) mehrfach auf, wird dieses Pixeltupel in einer Farbe dargestellt, die der Anzahl des Auftretens dieses Pixeltupels (x, y) zugeordnet ist. Der Benutzer kann z.B. auf dem Bildschirm neben den Darstellungsdaten noch eine Farbskala sehen, die die Häufigkeit eines Pixelpunktes oder deren Auftrittsanzahl mit einer Farbe verbindet und so den Spektralwerten eine Auftrittshäufigkeit zuordnen. Der Farbe des Anfangs der Farbskala wird vorzugsweise das einfache Auftreten eines Spektralwertes zugeordnet, während der Farbe am Ende der Farbskala zum Beispiel das N-fache Auftreten bzw. das maximale Auftreten eines Spektralwertes zugeordnet sein kann. Zusammenfassend wird also ein Darstellungsbild aus den N gesammelten Spektren berechnet, welches alle N Spektren zeigt und die Anzahl des einfachen oder mehrfachen Auftretens eines Pixelpunktes bzw. eines entsprechenden Leistungswert-Frequenzwert-Tupels über eine Farbskala darstellt.

Die in der Steuervorrichtung 20 berechneten Darstellungsdaten (entspricht den Steuerungsinformationen für die Pixeltupel) werden zum Beispiel als Bitmap an den digitalen Bildschirm 15 und/oder über eine Schnittstelle 16 an einen externen digitalen Bildschirm gegeben, um die Darstellungsdaten anzuzeigen. Die Darstellungsdaten könnten theoretisch für jedes neue gelieferte Einzelspektrum neu berechnet und an den Bildschirm gegeben werden. Da aber die Messrate der Einzelspektren wesentlich höher ist als die Auflösungsrate des menschlichen Auges und da aufgrund der Vielzahl N an Einzelspektren, ein Einzelspektrum an dem Gesamtbild kaum eine erkennbare Änderung bewirkt, ist es besonders vorteilhaft, die Darstellungsdaten nur in einer Rate neu zu berechnen und an den digitalen Bildschirm 15 zu geben, die im Bereich des Auflösungsverhaltens des menschlichen Auges liegt. So kann die Hardware für die Steuervorrichtung 20 und den digitalen Bildschirm 15 einfacher ausgeführt sein.

Über die Eingabevorrichtung 16, z.B. eine Computermaus, ein Touchscreen, eine Tastatur oder sonstige Eingabegeräte, kann der Benutzer Einstellungen, wie die Anzahl N der Spektren, die Berechnungsrate für die Darstellungsdaten, die Art der Farbskala für die Auftrittshäufigkeit der Spektralwerte, usw., vornehmen. Dadurch lassen sich die Darstellungsdaten an die Untersuchungsbedingungen und die Art des Messsignals anpassen.

Erfindungsgemäß wird zwischen dem digitalen Bildschirm 15 und der Akkumulationsvorrichtung 21 ein Filter 22 als Filtervorrichtung angeordnet. Der Filter 22 lässt Pixelpunkte mit denjenigen zugeordneten Farben, die einer ausgewählten Teilmenge der möglichen Anzahlen des Auftretens der Spektralwerte entsprechen, zu und unterbindet die Ansteuerung von Pixelpunkten, deren Farben nicht der ausgewählten Teilmenge der Auftrittshäufigkeiten der Spektralwerte entsprechen.

Ein Benutzer kann dabei die ausgewählte Teilmenge über eine Eingabevorrichtung 16 selbst einstellen. Ein TouchScreen oder eine Computermaus auf dem digitalen Bildschirm 15 ist zum Beispiel geeignet, um einen minimal und einen maximal dargestellten Häufigkeitswert auf einer dargestellten Farbskala, die die möglichen Häufigkeitswerte in Farbwerte übersetzt, einzustellen. Dieser eingestellte Bereich kann nachträglich auch hin zu höheren oder niedrigeren Häufigkeitsbereichen verstellt werden. Diese Informationen werden an den Filter 22 gegeben, der so eingestellt wird, dass nur alle Farben zwischen dem minimalen und maximal darzustellenden Häufigkeitswert auf dem Bildschirm dargestellt werden. Hierzu werden nur die zu den darzustellenden Werten gehörenden Darstellungsdaten weitergeleitet. Für die übrigen Bildschirmpunkte erfolgt eine weitere Ansteuerung mit der Hintergrundfarbe. Ergibt sich durch eine neue Einstellung durch den Benutzer eine neue Teilmenge, so wird diese direkt an den Filter 22 weitergeleitet und nur die neue Teilmenge wird auf dem digitalen Bildschirm 15 dargestellt.

Alternativ lässt sich ein solcher Filter 22 anstatt auf Farben 22 der Darstellungsdaten (x, y) auch direkt auf die Häufigkeiten der Spektralwerte anwenden. Nach einer solchen alternativen Filterung müsste natürlich noch die Frequenz-Leistungstupel, deren Auftrittshäufigkeit in der Teilmenge enthalten sind, in Darstellungsdaten (x, y) umgerechnet werden. Dies bietet die Möglichkeit, die alte Farbskala oder eine neue Farbskala der kleineren, ausgewählten Teilmenge neu zuzuordnen, um auch kleinere Häufigkeitsunterschiede farblich deutlicher darzustellen.

Vorzugsweise können auch zwei oder mehr getrennte Häufigkeitsbereiche als Teilmenge mit jeweils einem Minimal- und einem Maximalwert ausgewählt werden. Somit können auch zwei oder drei verschiedene Häufigkeitsbereiche von Interesse von dem restlichen Häufigkeitswerten separiert werden. Auch diese eingestellten Bereiche lassen sich jeweils auch als Häufigkeitsbereiche gegeneinander bzw. einzeln verschieben. Durch eine Überlappung zweier, solcher Häufigkeitsbereiche können zwei Bereiche zu einem großen Häufigkeitsbereich zusammengeführt werden. Durch weiteres Überlappen kann dann der zusammengeführte Häufigkeitsbereich weiter verkleinert werden.

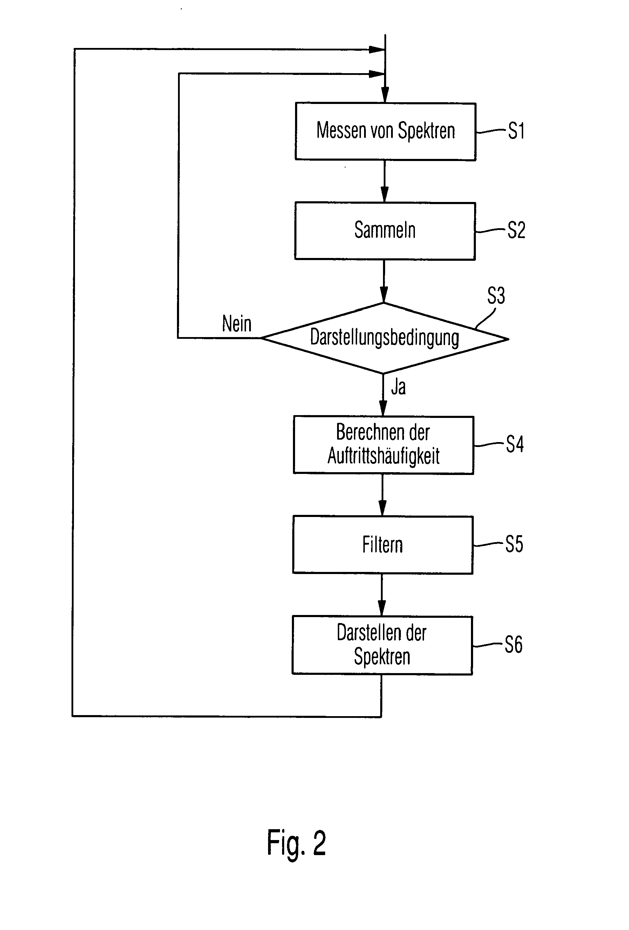

Fig. 2 zeigt vereinfacht die einzelnen Verfahrenschritte eines Ausführungsbeispiels des erfindungsgemäßen Verfahrens. In einem ersten Schritt S1 wird ein Einzelspektrum, wie zuvor bezüglich der Messvorrichtung 12 beschrieben, ermittelt. In einem zweiten Schritt S2 wird in der Akkumulationsvorrichtung 21 der Steuervorrichtung 20 das gemessene Einzelspektrum gespeichert. Ist bereits eine bestimmte Anzahl N an Einzelspektren gespeichert, wird das älteste Einzelspektrum gelöscht und das neue hinzugefügt.

In einem dritten Schritt S3 wird getestet, ob eine Darstellungsbedingung erfüllt ist. Eine solche Darstellungsbedingung kann am Anfang des Verfahrens zum Beispiel die Speicherung einer bestimmten Anzahl N von Spektren sein. Im Betrieb könnte die Darstellungsbedingung eine seit der letzten erfüllten Darstellungsbedingung vergangenen Zeit oder seit der letzten erfüllten Darstellungsbedingung neu gemessene und gespeicherte Anzahl von Einzelspektren sein. Ist die Darstellungsbedingung nicht erfüllt, werden Schritt S1, S2 und S3 wiederholt bis in S3 die Darstellungsbedingung erfüllt ist.

Ist die Darstellungsbedingung erfüllt, wird in Schritt S4 in der Akkumulationsvorrichtung 21 die Auftrittshäufigkeit einzelner Spektralwerte pro Frequenz in der Gesamtheit der N Einzelspektren berechnet. In Schritt S5 werden die Darstellungsdaten so gefiltert, dass nur Spektralwerte, die mit einer Auftrittshäufigkeit einer ausgewählte Teilmenge der möglichen Auftrittshäufigkeiten der Spektralwerte auftreten, in Form von Darstellungsdaten an den digitalen Bildschirm 15 gegeben werden und in Schritt S6 nur diese Spektralwerte auf dem digitalen Bildschirm 15 dargestellt werden. Die Auftrittshäufigkeiten der dargestellten Spektralwerte bleiben weiterhin optisch unterscheidbar, vorzugsweise über eine Farbskala, dargestellt.

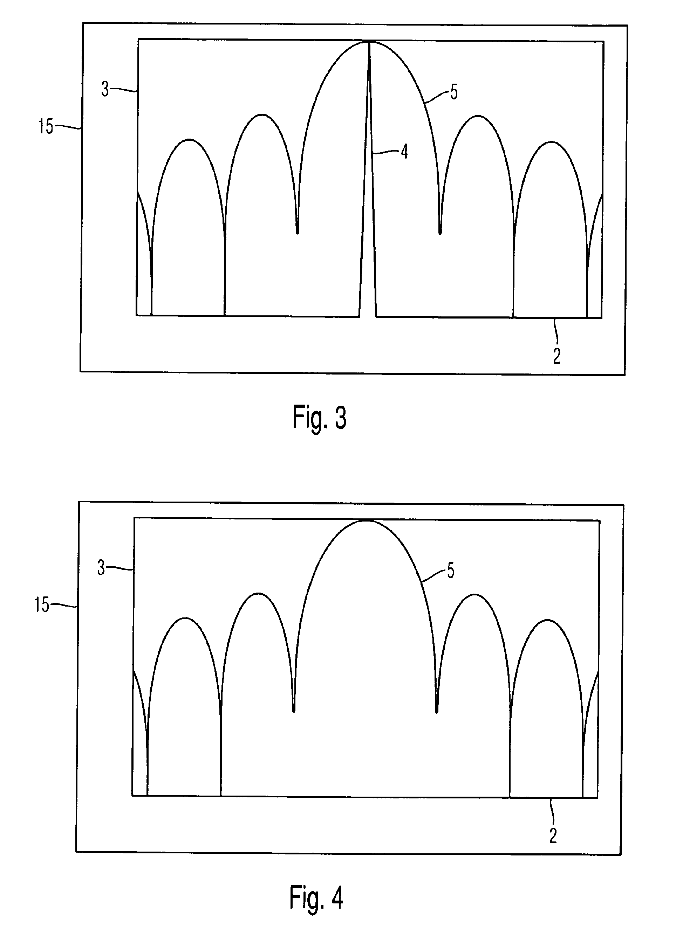

In der stark vereinfachten Darstellung in Fig. 3 wird eine Bildschirmdarstellung des Stands der Technik zweier unterschiedlicher Spektren 4 und 5 als Leistung 3 über die Frequenz 2 gezeigt. Die Leistungsspektren 4 und 5 treten dabei unterschiedlich oft auf. Dies ist normalerweise über eine unterschiedliche Farbe der Spektren 4 und 5 dargestellt. In dieser schwarz-weiß Darstellung wurde die unterschiedliche Häufigkeit durch die unterschiedliche Dicke der gezeichneten Spektren 4 und 5 dargestellt. Interessiert der Benutzer sich nun nur für das Kurzzeitspektrum 5, kann er auf dem digitalen Bildschirm 15 die entsprechenden Häufigkeitswerte bzw. deren Farbwerte auswählen und so wie in Fig. 4 dargestellt, das Kurzzeitspektrum 5 isolieren.

In dieser stark vereinfachten Darstellung mögen beide Spektren gut unterscheidbar sein, aber gerade bei nahe beieinander liegenden Spektralwerten und deren Farbwerten, ist eine solche Isolierung auf der Basis der Auftrittshäufigkeiten eine große Analysehilfe. Ohne Beschränkung der Erfindung sind die Spektren 4 und 5 interpoliert gezeichnet. Alternativ ist auch eine Punktdarstellung der Spektren 4 und 5 möglich. In diesem theoretischen Beispiel treten innerhalb des bestimmten Zeitintervalls der Messung der N Spektren nur zwei Spektren 4 und 5 auf, wobei das Spektrum 4 häufiger auftritt als das Spektrum 5. Bei der Beobachtung von realen Signalen, z.B. Empfangssignale von Antennen, gibt es vor allem im niedrigen Leistungsbereich eine starke Fluktuation der Spektralwerte durch das Empfangsrauschen.

Wird in dieser Anmeldung von einer Häufigkeit gesprochen, ist immer die Anzahl des Auftretens eines Spektralwertes bzw. eines einem Pixel entsprechenden Spektralwertebereichs pro Frequenzwert in der Gesamtheit der gemessenen N Einzelspektren gemeint. Ein Häufigkeitsbereich ist eine Menge an benachbarten, diskreten Häufigkeitswerten oder ein kontinuierliches Häufigkeitswerteintervall mit einem Maximal- und Minimalwert. Die Bezeichnung der Teilmenge wird vorliegend nur im Zusammenhang mit einer Teilmenge der möglichen Häufigkeitswerte benutzt. Die möglichen Häufigkeitswerte sind bei einer endlichen Anzahl N von gemessenen Einzelspektren die diskrete Werte 0, 1, ..., N. Die Teilmenge kann sich aus einer Anzahl M < N möglicher, diskreter, nicht notwendigerweise benachbarter Häufigkeitswerte zusammensetzen.

Unter verschiedenen Farben sind allgemein nicht nur Farben im Sinne von unterschiedlichen Wellenlängen im sichtbaren Bereich, sondern auch verschiedene Helligkeitswerte der gleichen Farbe und verschiedene Muster zu verstehen. Optisch unterscheidbar bezieht sich auf den optischen Bereich, der für das menschliche Auge wahrnehmbar ist.

Die Erfindung ist nicht auf das dargestellte Ausführungsbeispiel beschränkt. Vielmehr sind auch einzelne Merkmale des erfindungsgemäßen Messgeräts und des erfindungsgemäßen Verfahrens in vorteilhafter Weise kombinierbar.

## Patentansprüche

1. Verfahren zur Messdatenverarbeitung aufweisend die folgenden Schritte:
- Ermitteln einer Mehrzahl von zeitlich nacheinander liegenden Einzelspektren eines Signals in einem bestimmten Zeitintervall (S1);
- Berechnen der Häufigkeiten des Auftretens eines jeden Spektralwertes aus der Gesamtheit der in dem bestimmten Zeitintervall gemessenen Einzelspektren(S4);
**dadurch gekennzeichnet, dass**
nur die Spektralwerte auf einer Anzeigevorrichtung (15) dargestellt werden, die in einer ausgewählten Teilmenge der möglichen Auftrittshäufigkeiten der Spektralwerte liegen.

2. Verfahren nach Anspruch 1,
**dadurch gekennzeichnet,**
**dass** die dargestellten Spektralwerte entsprechend ihrer Häufigkeit des Auftretens optisch unterscheidbar dargestellt werden.

3. Verfahren nach Anspruch 2,
**dadurch gekennzeichnet,**
**dass** die dargestellten Spektralwerte jeweils als Punkte über die Frequenz dargestellt werden und die Häufigkeit des Auftretens der dargestellten Spektralwerte in den verschiedenen Einzelspektren durch eine Farbskala repräsentiert wird.

4. Verfahren nach einem der Ansprüche 1 bis 3,
**dadurch gekennzeichnet,**
**dass** die Teilmenge der möglichen Häufigkeiten des Auftretens der dargestellten Spektralwerte einstellbar ist.

5. Verfahren nach einem der Ansprüche 1 bis 4,
**dadurch gekennzeichnet,**
**dass** die Teilmenge der möglichen Häufigkeiten des Auftretens der dargestellten Spektralwerte mittels eines minimalen und eines maximalen Häufigkeitswerts auf einer der Häufigkeit entsprechenden Farbskala einstellbar ist.

6. Verfahren nach einem der Ansprüche 1 bis 5,
**dadurch gekennzeichnet,**
**dass** sich die Teilmenge aus mehreren einzelnen Teilbereichen der möglichen Häufigkeiten der Spektralwerte zusammensetzt.

7. Verfahren nach einem der Ansprüche 1 bis 6,
**dadurch gekennzeichnet,**
**dass** zunächst Darstellungsdaten für eine vollständige Darstellung der Spektralwerte unabhängig von ihrer Häufigkeit durch die Akkumulationsvorrichtung (21) ermittelt werden und anschließend eine Filterung durchgeführt wird.

8. Messgerät aufweisend
- eine Messvorrichtung (12) zum Ermitteln einer Mehrzahl von zeitlich nacheinander liegenden Einzelspektren eines Signals;
- eine Anzeigevorrichtung (15) zur Darstellung von Spektralwerten (3) über die Frequenz (2);
- eine Akkumulationsvorrichtung (21) verbunden mit der Anzeigevorrichtung (15) und der Messvorrichtung (12) zur Berechnung der Darstellungsdaten aus den gemessenen Einzelspektren der Messvorrichtung (12), wobei die Akkumulationsvorrichtung (21) so eingerichtet ist, dass die Spektraldaten aller Einzelspektren aus einem bestimmten Zeitbereich gesammelt werden und die Häufigkeiten des Auftretens eines jeden Spektralwertes aus der Gesamtheit der in dem bestimmten Zeitintervall gemessenen Einzelspektren berechenbar sind;
**dadurch gekennzeichnet, dass** das Messgerät weiterhin aufweist,
eine Filtervorrichtung (22) verbunden mit der Akkumulationsvorrichtung (21) zur Reduzierung der Darstellungsdaten auf diejenigen Spektralwerte, die in einer ausgewählten Teilmenge der möglichen Auftrittshäufigkeiten der Spektralwerte liegen.

9. Messgerät nach Anspruch 8,
**dadurch gekennzeichnet,**
**dass** in der Akkumulationsvorrichtung (21) Darstellungsdaten berechenbar sind, so dass die dargestellten Spektralwerte entsprechend ihrer Häufigkeit des Auftretens optisch unterscheidbar dargestellt werden.

10. Messgerät nach Anspruch 9,
**dadurch gekennzeichnet,**
**dass** in der Akkumulationsvorrichtung (21) Darstellungsdaten berechenbar sind, so dass die dargestellten Spektralwerte jeweils als Punkte (1) über die Frequenz dargestellt werden und die Häufigkeit des Auftretens der dargestellten Spektralwerte (1) in den verschiedenen Einzelspektren durch eine Farbskala repräsentiert wird.

11. Messgerät nach einem der Ansprüche 8 bis 10,
**dadurch gekennzeichnet,**
**dass** die Filtervorrichtung (22) mit einer Eingabevorrichtung (16) verbunden ist, so dass die Teilmenge der möglichen Häufigkeiten des Auftretens der dargestellten Spektralwerte einstellbar ist.

12. Messgerät nach Anspruch 11,
**dadurch gekennzeichnet,**
**dass** die Teilmenge der möglichen Häufigkeiten des Auftretens der dargestellten Spektralwerte über die Eingabevorrichtung (16) mittels eines minimalen und eines maximalen Häufigkeitswerts auf einer der Häufigkeit entsprechenden Farbskala einstellbar ist.

13. Messgerät nach einem der Ansprüche 8 bis 12,
**dadurch gekennzeichnet,**
**dass** sich die Teilmenge aus mehreren einzelnen Teilbereichen der möglichen Häufigkeiten der Spektralwerte zusammensetzt.

14. Messgerät nach einem der Ansprüche 8 bis 13,
**dadurch gekennzeichnet,**
**dass** in der Akkumulationsvorrichtung (21) Darstellungsdaten berechenbar sind, so dass alle Spektralwerte entsprechend ihrer Häufigkeit des Auftretens optisch unterscheidbar dargestellt werden und in der Filtervorrichtung (22) die Spektralwerte, die nicht in einer Häufigkeit der Teilmenge auftreten, mittels der optischen Eigenschaften der Spektralwerte herausgefiltert werden.
